# EUROPEAN PATENT SPECIFICATION

(11) **EP 0 277 597 B1**
(45) Date of publication and mention of the grant of the patent: **13.07.1994**
(21) Application number: 88101267.8
(22) Date of filing: 28.01.1988
(51) Int. Cl.: H01L 33/00, H01L 21/205, C30B 25/20

(54) **Gallium nitride group semiconductor light emitting diode and the process of producing the same**
Gallium-Nitrid Halbleiter-Lumisneszenzdiode sowie Verfahren zu deren Herstellung
Diode electroluminescente semiconductrice du type nitride de gallium et son procédé de fabrication

(30) Priority: 31.01.1987 JP 21124/87; 31.01.1987 JP 21126/87
(43) Date of publication of application: 10.08.1988
(60) Divisional application: 91113265.2
(73) Proprietor: TOYODA GOSEI CO., LTD., Nishikasugai-gun, Aichi-Pref., 492 (JP); NAGOYA UNIVERSITY, Chikusa-ku Nagoya City Aichi Prefecture (JP)
(72) Inventor: Manabe, Katsuhide, Ichinomiya-shi Aichi-pref.491 (JP); Okazaki, Nobuo, Konan-shi Aichi-pref. 483 (JP); Akasaki, Isamu, Machida-shi Tokyo 194-01 (JP); Hiramatsu, Kazumasa, Yokkaichi-shi Mie-pref. 510 (JP); Amano, Hiroshi, Hamamatsu-shi Shizuoka-pref. 432 (JP)
(74) Representative: Bühling, Gerhard, Dipl.-Chem.

(56) References cited:
- DE-A- 3 046 018
- GB-A- 2 123 607
- US-A- 3 683 240
- US-A- 4 152 182
- US-A- 4 404 265
- PATENT ABSTRACTS OF JAPAN, vol. 6, no. 32 (E-96)(910), 26 February 1982; & JP-A-56 150 880 (MATSUSHITA DENKI SANGYO) 21-11-1981
- PATENT ABSTRACTS OF JAPAN, vol. 6, no. 189 (E-133)(1067), 28 September 1982; & JP-A-57 102 081 (MATSUSHITA DENKI SANGYO) 24-06-1982
- PATENT ABSTRACTS OF JAPAN, vol. 9, no. 102 (E-312)(1825), 4 May 1985; & JP-A-59 228 776 (NIPPON DENSHIN DENWA KOSHA) 22-12-1984
- JOURNAL OF THE ELECTROCHEMICAL, vol. 125, no. 12, December 1978, pages 2076-2078, US; A. SHINTANI et al.: "X-Ray Diffraction Topography and Crystal Characterization of GaN Epitaxial Layers for Light-Emitting Diodes"
- JOURNAL OF APPLIES PHYSICS, vol. 56, no. 8, October 1984, pages 2367-2368, Woodbury, New York, US; T. KAWABATA et al.: "GaN blue light emitting diodes prepared by metal-organic chemical vapor deposition"
- PATENT ABSTRACTS OF JAPAN, vol. 10, no. 11 (E-374)(2068), 17 January 1985; & JP-A-60 175 468 (MATSUSHITA DENKI SANGYO) 09-09-1985
- APPLIES PHYSICS LETTERS, vol. 48, no. 5, 3 Febaruary 1986, pages 353-355, New York, US; H. AMANO et al.: "Metalorganic vapor phase epitaxial growth of a high quality GaN film using an AIN buffer layer"
- CRYSTAL RESEARCH AND TECHNOLOGY, vol. 15, no. 10, 1980, pages 1143-1149, East-Berlin, DDR; G. FITZL et al.: "Epitaxial Growth of GaN on (10/2) oriented Sapphire in GaCI/NH3/He and GaCI/NH3/H2 Systems"
- JOURNAL OF APPLIED PHYSICS, vol. 56, no. 8, October 1984, pages 2367-2368, Woodbury, New York, USA; T. KAWABATA et al.: "GaN blue light emitting diodes prepared by metalorganic chemical vapor deposition"
- JOURNAL OF THE ELECTROCHEMICAL SOCIETY, vol. 125, no. 12, December 1978, pages 2076-2078; A. SHINTANI et al.: "X-Ray Diffraction Topography and Crystal Characterization of GaN Epitaxial Layers for Light-Emitting Diodes"

## Description

The present invention relates to a gallium nitride group semiconductor light emitting diode and the process of producing the same.

In the past, the semiconductor and the light emitting diode formed by the vapor growth of a thin film of gallium nitride group semiconductor (AℓₓGa₁₋ₓN; inclusive of x = 0) on a sapphire substrate using the process of metalorganic vapor phase epitaxy (hereinafter referred to as "MOVPE") has been studied.

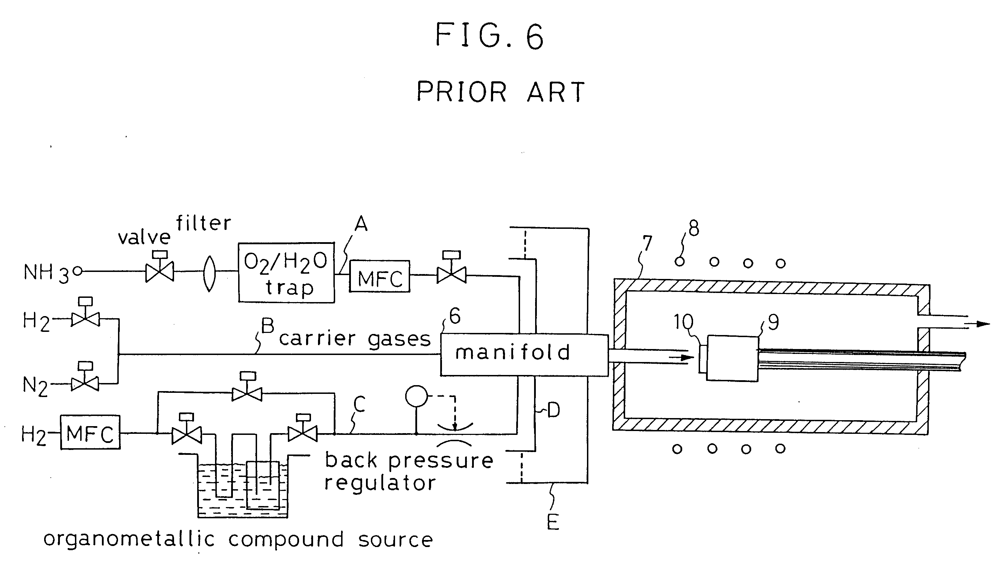

The MOVPE forming the light emitting diode and the semiconductor is conducted by using a vapor growth apparatus as shown in Fig. 6. In the vapor growth apparatus, a manifold 6 is connected to a quartz reaction tube 7 and a supply system A of NH₃, a supply system B of H₂ and N₂, a supply system C of trimethylgallium (hereinafter referred to as "TMG") of an organometallic compound gas, a supply system D of trimethylaluminum (hereinafter referred to as "TMA") of the organmetallic compound gas and a supply system E of diethylzinc (hereinafter referred to as "DEZ") which is a reactant gas containing a doping element (hereinafter referred to as "dopant gas") are connected to the manifold 6. Also, in the quartz reaction tube 7, a high frequency heating graphite susceptor 9 is provided, on which a sapphire substrate 10 is disposed, which is heated by a high frequency coil 8. Each reactant gas and carrier gas from each supply system are mixed in the manifold 6, and the mixed gas is led to the quartz reaction tube 7 and blown against the sapphire substrate 10 to grow an AℓₓGa₁₋ₓN thin film thereon.

Then, by changing the mixing ratio of each organometallic compound gas, the composition ratio can be changed and the insulated thin film of I-type (Intrinsic) AℓₓGa₁₋ₓN can be formed by doping zinc.

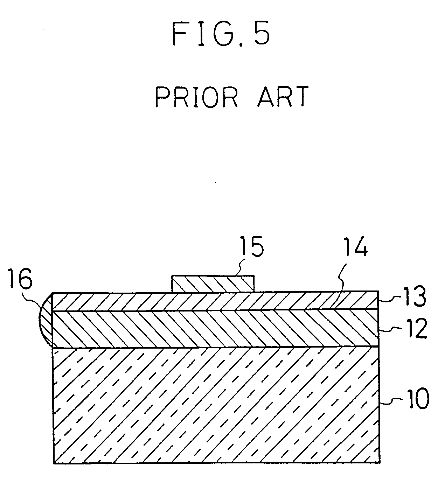

Also, one example of the light emitting diode produced specifically by the aforementioned MOVPE is, as shown in Fig. 5, constructed as such that an N layer 12 consisting of N-type GaN and an I layer 13 consisting of I-type GaN formed by doping zinc are formed on the sapphire substrate 10, an electrode 15 is formed on the upper surface of the I layer 13 and an electrode 16 is formed on the side of the N layer 12 so that the both layers are luminous at their joint.

Since the sapphire substrate is utilized in the light emitting diode, the electrode 16 has to be positioned on the side of the N layer 12, encountering difficulty in production.

Meanwhile, when forming the electrode 16 of the N layer 12 on the same surface as the electrode 15 of the I layer 13, it has been attempted to form the electrode on the N layer exposed by removing an insulated film, after selectively forming the I layer by masking with the insulated film evaporated in a prescribed pattern.

However, since selective growth of the I layer with the insulated film mask is somewhat difficult and the I layer is formed also on the insulated film, removing the insulated film alone is difficult.

In the past, when the vapor growth of the gallium nitride group semiconductor takes place on the sapphire substrate, a surface c ({0001}) has been considered appropriate as the main surface which is involved in the crystal growth.

JP-A 56-150 880 discloses a gallium nitride light emitting element chip and the manufacture thereof. The known gallium nitride group semiconductor LED comprises a sapphire substrate, an N-type GaN layer and on top of said layer an I-type GaN layer. On a part of the sapphire substrate an alumina film of such a thickness is formed that electrons cannot pass therethrough; due to the existence of said alumina film, however, the N-type GaN layer formed on top thereof shows a disordered structure which results in the existence of a conductive N-type crystal on said alumina layer. Accordingly the electron path in the gallium nitride group semiconductor LED according to JP-A 150 880 is constituted by the side surface of the conductive N-type crystal showing a disordered structure, the side surface of the N-type GaN layer and the I-type GaN layer.

It is, therefore, a primary object of the present invention to provide a blue light emitting diode which is easy to produce and high in quality and the process of producing the same.

It is another object of the present invention to provide a gallium nitride group semiconductor light emitting diode grown on a sapphire substrate and having good quality and the process of producing the same.

It is a further object of the present invention to provide a light emitting diode which is easy to produce and simple to handle and having electrodes formed on the same plane.

Fig. 1 is a structural view showing an apparatus for vapor growth for embodying the present invention.

Fig. 2 is a sectional view showing the structure of a light emitting diode.

Fig. 3(a) is an SEM image showing a sectional construction of a GaN layer grown on an N layer.

Fig. 3(b) is an SEM image showing a sectional construction of a GaN layer grown on a SiO₂ thin film.

Fig. 4(a) is an RHEED pattern of a GaN layer grown on an N layer.

Fig. 4(b) is an RHEED pattern of a GaN layer grown on a SiO₂ film.

Fig. 5 is a sectional view showing the structure of a conventional light emitting diode.

Fig. 6 is a structural view showing the structure of a conventional apparatus for vapor growth.

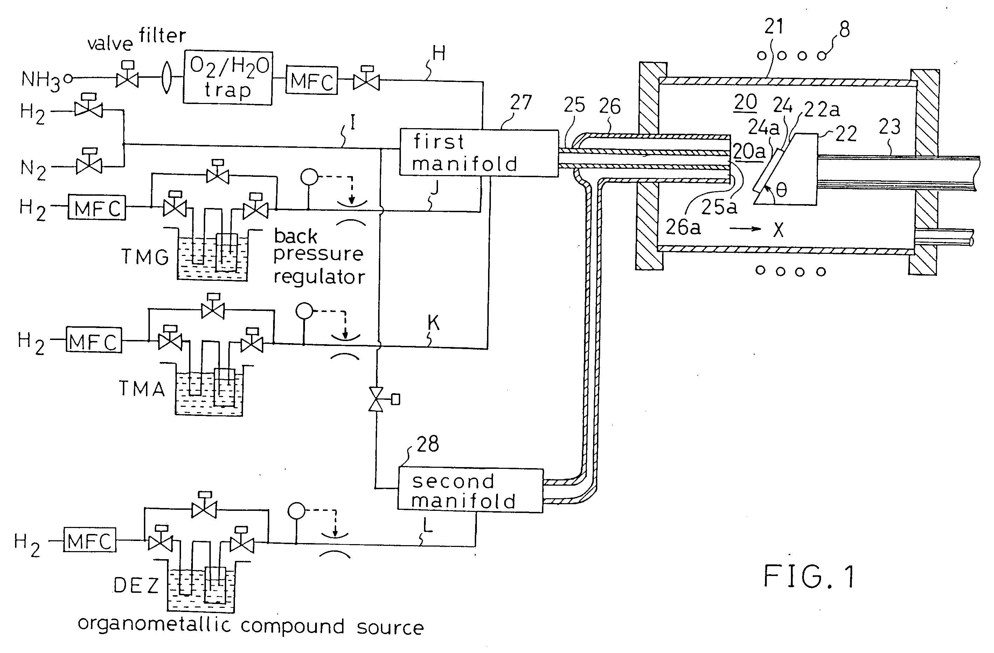

The present invention will be described in the following referring to the specific embodiment. Fig. 1 is a structural view showing an apparatus for vapor growth for producing a semiconductor and a light emitting diode according to the present invention.

In a reaction chamber 20 surrounded by a quartz reaction tube 21, a susceptor 22 is supported by a control rod 23 for adjustment. On the main surface 22a of the susceptor 22, a sapphire substrate 24 having the main surface 24a which is subjected to the crystal growth is disposed. The numeral 8 generally denotes a high frequency coil for heating the sapphire substrate 24.

Meanwhile, on the gas inlet side of the reaction chamber 20, a first reactant gas tube 25 and a second reactant gas tube 26 are arranged. The first reactant gas tube 25 is disposed concentrically within the second reactant gas tube 26, the former being connected to a first manifold 27 and the latter being connected to a second manifold 28. To the first manifold 27, a supply system H of NH₃, a supply system I of a carrier gas, a supply system J of TMG and a supply system K of TMA are connected, and to the second manifold 28, the supply system I of the carrier gas and a supply system L of DEZ are connected.

Since the apparatus is constructed as such, from the opening 25a of the first reactant gas tube 25, mixed gas of NH₃, TMG, TMA and H₂ flows out into the reaction chamber 20, and from the opening 26a of the second reactant gas tube 26, a mixed gas of DEZ and H₂ flows out into the reaction chamber 20.

When forming an N-type AℓₓGa₁₋ₓN thin film, the mixed gas may be introduced only from the first reactant gas tube 25, and when forming an I-type AℓₓGa₁₋ₓN thin film, the mixed gas may be introduced respectively from the first reactant gas tube 25 and the second reactant gas tube 26. When forming the I-type AℓₓGa₁₋ₓN thin film, DEZ which is the dopant gas is mixed with the reactant gases introduced from the first reactant gas tube 25 only at a reaction chamber 20a in the vicinity of the sapphire substrate 24. Then, DEZ is blown against the sapphire substrate and decomposed thermally, a dopant element is doped to growing AℓₓGa₁₋ₓN to yield I-type AℓₓGa₁₋ₓN. In this case, since the reactant gas and dopant gas are completely separated by the first and second reactant gas tubes 25, 26 and led to a reaction chamber 20a near the sapphire substrate 24, reaction between DEZ and TMG or TMA within the feed tube of the gas occurred in the prior art apparatus is restrained, so that the doping is effected satisfactorily.

It is preferable that the openings 25a and 26a of the first and second reactant gas tubes 25, 26 and the sapphire substrate 24 are spaced at 10 to 60 mm. Also, an inclined angle ϑ of the main surface 22a of the susceptor 22 relative to the direction X of the reactant gas flow is set at 45°. In this arrangement, a better crystal was yielded as compared with the case where the susceptor 22 is arranged normally to the gas flow.

Next, utilizing the apparatus for vapor growth, the GaN thin film was optionally formed on the sapphire substrate including the surface a ({112̅0}) as the main surface as follows.

First, the single crystal sapphire substrate 24 including the surface a ({112̅0}) as the main surface, which is cleaned with the organic cleansing and heat treatment, is disposed on the main surface 22a of the susceptor 22. The sapphire substrate 24 is then subjected to the vapor etching at 1100°C as feeding H₂ from the first and second reactant gas tubes 25, 26 into the reaction chamber 20 at the flow rate of 0.3 ℓ/min. Next, the heat treatment was performed for 1 minute as lowering the temperature to 950°C and supplying H₂ at 3 ℓ/min. NH₃ at 2 ℓ/min. and TMA at 7 x 10⁻⁶ mols/min. from the first reactant gas tube 25. By the heat treatment, an AℓN buffer layer of 0.1 »m thick was formed on the sapphire substrate 24. The supply of TMA was suspended after one minute and the temperature of sapphire substrate 24 was kept at 970°C, then H₂ was supplied at 2.5 ℓ/min., NH₃ at 1.5 ℓ/min. and TMG at 1.7 x 10⁻⁵ mols/min. for 60 minutes from the the first reactant gas tube 25 to form the GaN thin film of 7 »m thick.

SEM images of the GaN thin film surface thus formed can be obtained and its luminous characteristics can be measured.

Meanwhile, also on the sapphire substrate optionally used including the surface c ({0001}) as the main surface, the GaN thin film was grown as similarly as the aforementioned process.

As it is apparent from said SEM images the GaN thin film grown on the sapphire substrate of the surface a ({112̅0}) has larger and more hexagonal crystals with better crystallinity compared to those grown on the sapphire substrate of the surface c ({0001}). While, in the characteristic of the photoluminescence intensity a half-width is 4.6 meV in the case of the surface c ({0001}) and that is 6 meV in the case of the surface a ({112̅0}). Therefore, as far as viewing from the photoluminescence intensity the crystallinity is generally same as that grown on the surface c ({0001}).

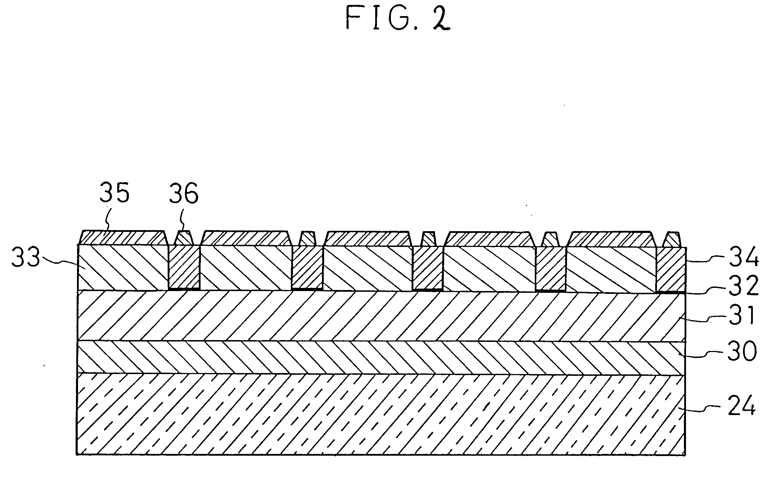

A process of producing a light emitting diode by the crystal growth of GaN on the sapphire substrate will be now described referring to Fig. 1 and Fig. 2.

The single crystal sapphire substrate 24 optionally used including the surface c ({0001}) as the main surface, which is cleaned by the organic cleansing and heat treatment, is first disposed on the main surface 22a of the susceptor 22. The sapphire substrate 24 was then subjected to the vapor etching at 1100°C by feeding H₂ from the first and second reactant gas tubes 25, 26 into the reaction chamber 20 at a flow rate of 0.3 ℓ/min. Next, the heat treatment was performed for 1 minute by lowering the temperature to 950°C and supplying H₂ at 3 ℓ/min., NH₃ at 2 ℓ/min. and TMA at 7 x 10⁻⁶ mols/min. from the first reactant gas tube 25, thereby a 0.1 »m thick AℓN buffer layer 30 was formed. By suspending the supply of TMA after 1 minute and keeping the temperature of the sapphire substrate 24 at 970°C, H₂ was supplied at 2.5 ℓ/min., NH₃ at 1.5 ℓ/min. and TMG at 1.7 x 10⁻⁵ mols/min. from the first reactant gas tube 25 for 60 minutes to form an N layer 31 consisting of a N-type GaN thin film of about 7 »m thick. Next, the sapphire substrate 24 was taken out from the reaction chamber 20, and the main surface of the N layer 31 coated with a photoresist was etched after being exposed by using a mask with prescribed pattern to form the photoresist with prescribed pattern thereon. Using the photoresist as the mask, a SiO₂ film 32 of about 10 mm (100 Å) film thickness was patterned. Thereafter, the photoresist was removed and the sapphire substrate 24 patterned only with the SiO₂ film 32 was cleaned, remounted on the susceptor 22 and subjected to vapor etching.

Then, by keeping the temperature of the sapphire substrate 24 at 970°C and feeding H₂ at 2.5 ℓ/min., NH₃ at 1.5 ℓ/min. and TMG at 1.7 x 10⁻⁵ mols/min. from the first reactant gas tube 25, and DEZ at 5 x 10⁻⁶ mols/min. from the second reactant gas tube 26 for 5 minutes, an I-layer 33 consisting of I-type GaN was grown to film thickness of 1.0 »m. At this time, on the window portion where the N layer 31 of GaN is exposed, single crystal I-type GaN is grown to yield the I layer 33, but on the SiO₂ film 32, a conductive layer 34 consisting of polycrystalline GaN is formed. Since the conductive layer 34 is polycrystalline, it has conductivity.

Then, the sapphire substrate 24 was taken out from the reaction chamber 20, aluminum electrodes 35, 36 were evaporated on the I layer 33 and the conductive layer 34, and the sapphire substrate 24 was cut into the prescribed size to form the light emitting diode. In this case, the electrode 35 acts as the electrode for the I layer 33 and the electrode 36 for the N layer 31 through the conductive layer 34 and the very thin SiO₂ film 32. Then, by bringing the I layer 33 at a positive potential with respect to the N layer 31, the junction between the two layers becomes luminous.

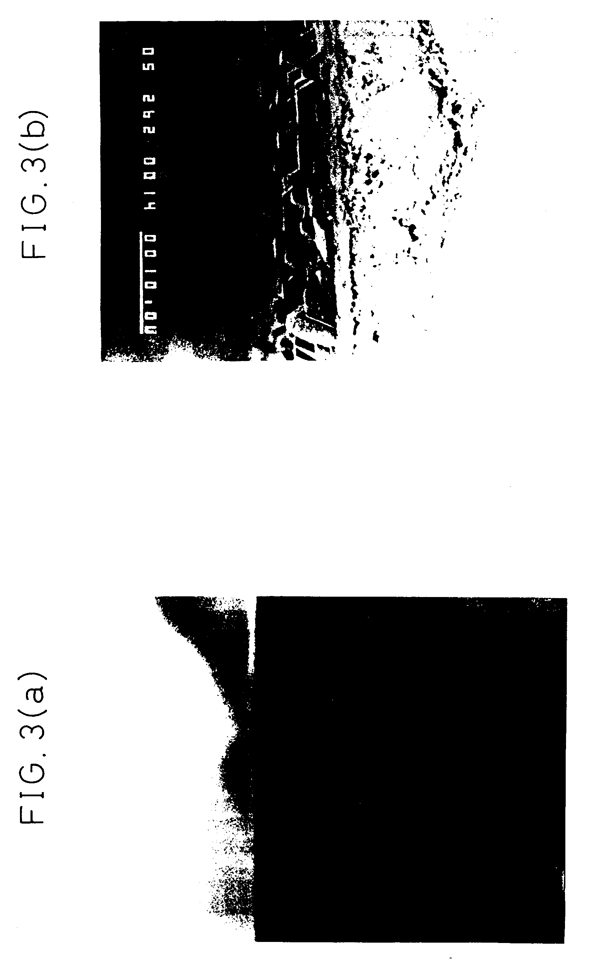

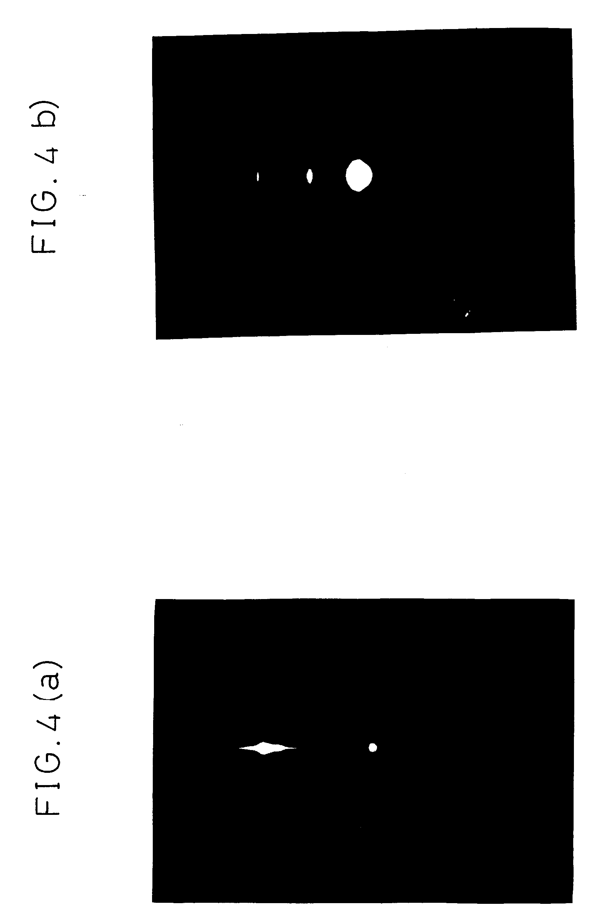

A sectional SEM image of the I layer 33 grown on the N layer 31 is shown in Fig. 3(a) and reflective high energy electron diffraction (RHEED) pattern is shown in Fig. 4(a). Also, an SEM image of the conductive layer 34 grown on the SiO₂ film 32 is shown in Fig. 3(b) and an RHEED pattern is shown in Fig. 4(b). As it will be apparent from these photographs, on N-type GaN, single crystal GaN is grown and on the SiO₂ film, polycrystalline GaN is grown, which has a higher conductivity as compared with the former and forms the conductive layer 34 and acts as a lead to the N layer 31.

In forming the AℓₓGa₁₋ₓN group light emitting diode, TMA may be introduced from the first reactant gas tube 25 at a prescribed rate when forming the N layer 31 and I layer 33. For example, by maintaining the temperature of the sapphire substrate 24 at 1105°C and supplying H₂ at 3 ℓ/min., NH₃ at 2 ℓ/min., TMA at 7.2 x 10⁻⁶ mols/min. and TMG at 1.7 x 10⁻⁵ mols/min. from the first reactant gas tube 25 and DEZ at 5 x 10⁻⁶ mols/min. from the second reactant gas tube 26, the I-type AℓₓGa₁₋ₓN (x = 0.3) group semiconductor thin film can be obtained.

## Claims

1. A gallium nitride group semiconductor light emitting diode comprising:
an N layer (31) of an N-type gallium nitride group semiconductor (AlₓGa₁₋ₓN; inclusive of x=0), carriers of which are electrons and which exhibits an N-type electric conduction,
a single crystalline I layer (33) of an I-type gallium nitride group semiconductor (AlₓGa₁₋ₓN; inclusive of x=0), which is selectively grown on exposed portions of said N layer (31) and is an insulator, wherein a very thin SiO₂ film (32) is partially formed with a predetermined pattern on a surface of said N layer (31) so thin that electrons can pass therethrough to reach said N layer, said pattern defining the exposed portions of said N layer (31) and
an electric lead (34) for conducting electrons to said N layer through said very thin SiO₂ film (32) and exhibiting electric conduction and being formed on said predetermined pattern of said very thin SiO₂ film (32) by a non-single crystalline gallium nitride group semiconductor (AlₓGa₁₋ₓN; inclusive of x=0) selectively grown on said very thin SiO₂ film (32) in a simultaneous growing process with said I layer (33) .

2. A gallium nitride group semiconductor light emitting diode according to claim 1, **wherein** a sapphire is used as a substrate and a buffer layer of aluminum nitride (AlN) is formed on a surface of said sapphire substrate and said N layer is formed on said buffer layer.

3. A gallium nitride group semiconductor light emitting diode according to claim 2, **wherein** the surface of said sapphire substrate is a surface "a"({1120}).

4. A gallium nitride group semiconductor light emitting diode according to claim 2, **wherein** the surface of said sapphire substrate is a surface "c"({0001}).

5. A process for producing a gallium nitride group semiconductor light emitting diode, wherein
an N layer (31) of an N-type gallium nitride group semiconductor (AlₓGa₁₋ₓN; inclusive of x=0), carriers of which are electrons and which exhibits an N-type electric conduction is formed,
a very thin SiO₂ film (32) is partially formed with a predetermined pattern on a surface of said N layer, so thin that electrons can pass therethrough to reach said N layer, and
a single crystalline I layer (33) of an insulative gallium nitride group semiconductor (AlₓGa₁₋ₓN; inclusive of x=0) is selectively grown on exposed portions of said N layer (31) which are defined by the predetermined pattern of said very thin SiO₂ film (32),
an electric lead (34) for conducting electrons to said N layer through said very thin SiO₂ film (32) and exhibiting an electric conduction and being formed on said predetermined pattern of said very thin SiO₂ film (32) by a non-single crystalline gallium nitride group semiconductor (AlₓGa₁₋ₓN; inclusive of x=0) selectively grown on said very thin SiO₂ film (32) in a simultaneous growing process with said I layer (33).

6. A process for producing a gallium nitride group semiconductor light emitting diode according to claim 5, **wherein** a sapphire is used as a substrate and a buffer layer of aluminum nitride (AlN) is formed on a surface of said sapphire substrate and said N layer is formed on said buffer layer.

7. A process of producing a gallium nitride group semiconductor light emitting diode according to claim 6, **wherein** the surface of said sapphire substrate is a surface "a"({1120}).

8. A process of producing a gallium nitride group semiconductor light emitting diode according to claim 6, **wherein** the surface of said sapphire substrate is a surface "c"({0001}).

## Patentansprüche

1. Gallium-Nitrid Halbleiter-Lumineszenzdiode mit
einer N-Schicht (31) aus einem N-Typ Gallium-Nitrid-Halbleiter (AlₓGa₁₋ₓN; inklusive x = 0), deren Ladungsträger Elektronen sind und die N-leitend ist,
einer einkristallinen I-Schicht (33) aus einem I-Typ Gallium-Nitrid-Halbleiter (AlₓGa₁₋ₓN; inklusive x = 0), die selektiv auf freiliegenden Abschnitten der N-Schicht (31) aufgewachsen ist und ein Isolator ist, wobei
ein äußerst dünner SiO₂-Film (32) mit einem vorbestimmten Muster auf Abschnitten der Oberfläche der N-Schicht (31) derart dünn ausgebildet ist, daß Elektronen zum Erreichen der N-Schicht hindurch gelangen können, wobei das Muster die freiliegenden Abschnitte der N-Schicht (31) bestimmt, und daß
eine elektrische Leitfähigkeit aufweisende elektrische Zuführung (34) zum Leiten von Elektronen durch den äußerst dünnen SiO₂-Film (32) zu der N-Schicht auf dem vorbestimmten Muster des äußerst dünnen SiO₂-Films (32) als nichteinkristalliner Gallium-Nitrid-Halbleiter (AlₓGa₁₋ₓN; inklusive x = 0) ausgebildet ist, wobei die Zuführung (34) gleichzeitig mit der I-Schicht (33), in demselben Abscheidungsschritt, selektiv auf dem äußerst dünnen SiO₂-Film (32) aufgewachsen wird.

2. Gallium-Nitrid Halbleiter-Lumineszenzdiode nach Anspruch 1, wobei Saphir als Substrat verwendet wird, eine Zwischenschicht aus Aluminiumnitrid (AlN) auf einer Oberfläche des Saphirsubstrats ausgebildet ist und die N-Schicht auf der Zwischenschicht ausgebildet ist.

3. Gallium-Nitrid Halbleiter-Lumineszenzdiode nach Anspruch 2, wobei die Oberfläche des Saphirsubstrats eine Oberfläche "a" ({1120}) ist.

4. Gallium-Nitrid Halbleiter-Lumineszenzdiode nach Anspruch 2, wobei die Oberfläche des Saphirsubstrats eine Oberfläche "c" ({0001}) ist.

5. Verfahren zum Herstellen einer Gallium-Nitrid Halbleiter-Lumineszenzdiode, bei dem
eine N-Schicht (31) aus einem N-Typ Gallium-Nitrid-Halbleiter (AlₓGa₁₋ₓN; inklusive x = 0), deren Ladungsträger Elektronen sind und die N-leitend ist, ausgebildet wird,
ein äußerst dünner SiO₂-Film (32) mit einem vorbestimmten Muster auf Abschnitten der Oberfläche der N-Schicht (31) derart dünn ausgebildet wird, daß Elektronen zum Erreichen der N-Schicht hindurch gelangen können,
eine einkristalline I-Schicht (33) aus einem isolierenden Gallium-Nitrid-Halbleiter (AlₓGa₁₋ₓN; inklusive x = 0) selektiv auf durch das vorbestimmte Muster des äußerst dünnen SiO₂-Films (32) bestimmten freiliegenden Abschnitten der N-Schicht (31) abgeschieden wird,
eine elektrische Leitfähigkeit aufweisende elektrische Zuführung (34) zum Leiten von Elektronen durch den äußerst dünnen SiO₂-Film (32) zu der N-Schicht auf dem vorbestimmten Muster des äußerst dünnen SiO₂-Films (32) als nichteinkristalliner Gallium-Nitrid-Halbleiter (AlₓGa₁₋ₓN; inklusive x = 0) ausgebildet wird, wobei die Zuführung (34) gleichzeitig mit der I-Schicht (33), in demselben Abscheidungsschritt, selektiv auf dem äußerst dünnen SiO₂-Film (32) abgeschieden wird.

6. Verfahren zum Herstellen einer Gallium-Nitrid Halbleiter-Lumineszenzdiode nach Anspruch 5, wobei Saphir als Substrat verwendet wird, eine Zwischenschicht aus Aluminiumnitrid (AlN) auf einer Oberfläche des Saphirsubstrats ausgebildet wird und die N-Schicht auf der Zwischenschicht ausgebildet wird.

7. Verfahren zum Herstellen einer Gallium-Nitrid Halbleiter-Lumineszenzdiode nach Anspruch 6, wobei die Oberfläche des Saphirsubstrats eine Oberfläche "a" ({1120}) ist.

8. Verfahren zum Herstellen einer Gallium-Nitrid Halbleiter-Lumineszenzdiode nach Anspruch 6, wobei die Oberfläche des Saphirsubstrats eine Oberfläche "c" ({0001}) ist.

## Revendications

1. Diode électroluminescente semi-conductrice du groupe nitrure de gallium comprenant :
une couche N (31) de semi-conducteur du groupe nitrure de gallium de type N (alₓGa₁₋ₓN ; x pouvant être égal à 0), des véhicules de cette couche qui sont des électrons, cette couche présente une conduction électrique de type N,
une couche I monocristalline (33) de semi-conducteur du groupe nitrure de gallium de type I (AlₓGa₁₋ₓN ; x pouvant être égal à 0), qu'on fait grossir sélectivement sur des portions exposées de ladite couche N (31) et qui est isolante, dans laquelle un film très mince de SiO₂ (32) est partiellement formé selon un dessin prédéterminé sur une surface de ladite couche N (31) avec une finesse telle que les électrons peuvent la traverser pour atteindre ladite couche N, ledit dessin définissant les portions exposées de ladite couche N (31) et
un conducteur électrique (34) pour conduire les électrons vers ladite couche N à travers ledit film de SiO₂ très mince (32) et qui présente une conduction électrique et est formé sur ledit dessin prédéfini du film de SiO₂ très mince (32) d'un semi-conducteur du groupe nitrure de gallium non monocristallin (AlₓGa₁₋ₓN ; x pouvant être égal à 0) développé sélectivement sur ledit film très mince de SiO₂ (32) au cours d'un processus simultané de croissance de ladite couche I (33).

2. Diode électroluminescente semi-conductrice du groupe nitrure de gallium selon la revendication 1, dans laquelle on utilise un saphir comme substrat et une couche tampon de nitrure d'aluminium (AlN) est formée sur une surface dudit substrat de saphir et ladite couche N est formée sur ladite couche tampon.

3. Diode électroluminescente semi-conductrice du groupe nitrure de gallium selon la revendication 2, dans laquelle la surface dudit substrat de saphir est une surface "a" ({1120}).

4. Diode électroluminescente semi-conductrice du groupe nitrure de gallium selon la revendication 2, dans laquelle la surface dudit substrat de saphir est une surface "c" ({0001}).

5. Procédé de fabrication d'une diode électroluminescente semi-conductrice du groupe nitrure de gallium comprenant :
une couche N (31) de semi-conducteur du groupe nitrure de gallium du type N (AlₓGa₁₋ₓN ; x pouvant être égal à 0), des véhicules de cette couche qui sont des électrons, cette couche présente une conduction électrique de type N,
un film très mince de SiO₂ (32) est partiellement formé selon un dessin prédéterminé sur une surface de ladite couche N avec une finesse telle que les électrons peuvent la traverser pour atteindre ladite couche N, et
une couche I monocristalline (33) de semi-conducteur du groupe nitrure de gallium isolant de type I (AlₓGa₁₋ₓN ; x pouvant être égal à 0), qu'on fait grossir sélectivement sur des portions exposées de ladite couche N (31) qui sont définies par le dessin prédéterminé du film très mince de SiO₂ (32),
un conducteur électrique (34) pour conduire les électrons vers ladite couche N à travers ledit film de SiO₂ très mince (32) et qui présente une conduction électrique et est formé sur ledit dessin prédéfini du film de SiO₂ très mince (32) d'un semi-conducteur du groupe nitrure de gallium non monocristallin (AlₓGa₁₋ₓN ; x pouvant être égal à 0) développé sélectivement sur ledit film très mince de SiO₂ (32) au cours d'un processus simultané de croissance de ladite couche I (33).

6. Procédé de fabrication d'une diode électroluminescente semi-conductrice du groupe nitrure de gallium, selon la revendication 5, dans lequel on utilise un saphir comme substrat et on forme une couche tampon de nitrure d'aluminium (AlN) sur une surface dudit substrat de saphir et on forme ladite couche N sur ladite couche tampon.

7. Procédé de fabrication d'une diode électroluminescente semi-conductrice du groupe nitrure de gallium, selon la revendication 6, dans laquelle la surface dudit substrat de saphir est une surface "a" ({1120}).

8. Procédé de fabrication d'une diode électroluminescente semi-conductrice du groupe nitrure de gallium, selon la revendication 6, dans laquelle la surface dudit substrat de saphir est une surface "c" ({0001}).
